# EUROPEAN PATENT SPECIFICATION

(11) **EP 3 782 095 B1**
(45) Date of publication and mention of the grant of the patent: **10.04.2024**
(21) Application number: 19725217.4
(22) Date of filing: 10.04.2019
(51) Int. Cl.: G06Q 10/06, G06Q 10/08, G06Q 10/10, G06Q 10/00

(54) **MONITORING EQUIPMENT, MONITORED SYSTEM INCLUDING SUCH EQUIPMENT, AND RELATED MONITORING PROCESS**
ÜBERWACHUNGSAUSRÜSTUNG, ÜBERWACHTES SYSTEM MIT SOLCH EINER AUSRÜSTUNG UND ZUGEHÖRIGES ÜBERWACHUNGSVERFAHREN
ÉQUIPEMENT DE SURVEILLANCE, SYSTÈME SURVEILLÉ COMPRENANT UN TEL ÉQUIPEMENT, ET PROCÉDÉ DE SURVEILLANCE ASSOCIÉ

(30) Priority: 16.04.2018 IT 201800004579
(43) Date of publication of application: 24.02.2021
(73) Proprietor: Carloni, Nicola, 47122 Forli (IT)
(72) Inventor: Carloni, Nicola, 47122 Forli (IT)
(74) Representative: Busca, Andrea
(86) International application number: PCT/IB2019/052962
(87) International publication number: WO 2019/202439

(56) References cited:
- WO-A1-2015/041082
- WO-A2-2005/006363
- JP-A- 2005 138 738
- US-A1- 2008 275 605
- US-B1- 7 100 289
- João Gil Josué ET AL: "Home Electric Energy Monitoring System: Design and Prototyping" In: "Technological Innovation for Sustainability", 1 January 2011 (2011-01-01), Springer Berlin Heidelberg, Berlin, Heidelberg, XP055680022, ISBN: 978-3-642-19169-5 vol. 349, pages 437-444, DOI: 10.1007/978-3-642-19170-1_48,
- Thomson Reuters: "machine translation of JP2005138738", , 1 January 2018 (2018-01-01), page 52, XP055516790, Retrieved from the Internet: URL:file:///C:/Meus%20documentos,%20no%20B ackup/Asian%20machine%20translations/JP200 5138738.pdf [retrieved on 2018-10-18]
- R. Bharathi ET AL: "Power Consumption Monitoring System using IOT", International Journal of Computer Applications, 1 September 2017 (2017-09-01), pages 975-8887, XP055680019, DOI: 10.5120/ijca2017915157 Retrieved from the Internet: URL:https://www.ijcaonline.org/archives/vo lume173/number5/bharathi-2017-ijca-915157. pdf [retrieved on 2020-03-26]
- Thomson Reuters: "machine translation of WO2015041082", , 1 January 2018 (2018-01-01), page 8, XP055516776, Retrieved from the Internet: URL:file:///C:/Meus%20documentos,%20no%20B ackup/Asian%20machine%20translations/WO201 5041082.pdf [retrieved on 2018-10-18]
- MARCU MARIUS ET AL: "Applications of smart metering and home appliances' power signatures", 2014 IEEE INTERNATIONAL INSTRUMENTATION AND MEASUREMENT TECHNOLOGY CONFERENCE (I2MTC) PROCEEDINGS, IEEE, 12 May 2014 (2014-05-12), pages 331-335, XP032620921, DOI: 10.1109/I2MTC.2014.6860762 [retrieved on 2014-07-18]

## Description

The present invention relates to an equipment for monitoring a plurality of service provision centers, which offer services to the public by means of machines operated by an operator. The invention also relates to a monitored system comprising such equipment and a relative monitoring process. Service provision centers are remote centers, for example branches of a company.

The invention has been devised with particular reference to centers comprising each a plurality of machines designed to perform predetermined services, such as for example service workshops for vehicle tires, where the operations carried out are of predetermined typologies, and therefore can be considered standardized. The application of the invention to other typologies of centers, such as, for example, mechanical workshops for vehicle repairs, is not excluded.

For the sake of simplicity, but not limited thereto, reference hereinafter will be made to the field of vehicle tire service centers. In the case of small workshops, each is generally owned by the same person who manages it, so there are no monitoring problems.

In the case of a company that manages a chain of branches through employees, there is a gap in the monitoring system to establish whether each operation performed in each service provision center has been computed and therefore monetized.

The company must necessarily place its trust in the manager of each workshop.

Furthermore, although the operations performed to provide the services are the same, the machines that perform them may have different brands, models and sizes, which introduces a significant obstacle to centralized monitoring. On the other hand, the idea of standardizing the machines of each branch could mean a serious investment that outweighs the benefit.

In addition, often a complete service that can be monetized consists of several simple operations of different typologies, thus resulting in a complex operation of difficult automatic recognition for the purpose of calculating the number thereof.

The need for a system for monitoring the number and/or typology of operations performed, which is easy and cost-effective to implement, is therefore felt in the field.

In the patent literature, electronic aids are known for storing certain parameters in the tire sector, however they are unrelated to the solution of the above need.

In particular WO2015/041082 relates to the problem of recycling the tires of demolished cars. This international patent application proposes to collect various data relating to the state of wear of the tires (tread height) by means of cameras and sensors to decide whether to send them to re-use or to disposal.

JP2005138738 relates to the problem of keeping track of the history of the services undergone by a tire. The data stored by the system relate to assembly and disassembly and are: tire identification code, vehicle identification code, tire mounting position, vehicle mileage upon assembly/disassembly, typology of assembly or disassembly work performed.

WO2005/006363 relates to a system for detecting damage to the local electricity network through readings of electrical absorption. Readings are carried out by sensors placed at electrical loads in the home.

The general object of the present invention is to partly overcome the problems of the prior art and to provide a monitoring system that meets said need.

US 7 100 289 B1 relates to a system for tire maintenance comprising a processor controlled wheel alignment system and ramp.

MARCU MARIUS ET AL: "Applications of smart metering and home appliances' power signatures" (DOI: 10.1109/I2MTC.2014.6860762) relates to measuring power signatures of home appliances. Certain operations of the applicances are identfied from the measured power signatures.

In brief, the present invention relates to a monitored system capable of computing the number of complex operations of various typologies composed of a plurality of simple operations performed by machines of various typologies. The system uses the reading of the variations in the electrical absorption of the machines associated with the absorption time and the typology of machine.

The invention is defined in the appended claims.

According to claim 1 the present invention relates to a monitored system for providing services to the public comprising:
- a plurality of electric absorption operating machines as defined in claim 1
- a monitoring equipment comprising:
- at least one central processing and monitoring apparatus (20);
- at least a plurality of devices for reading the electric absorption spectrum (15), each associated with an operating machine (10), and being in data communication with the central processing and monitoring apparatus (20) or being part thereof;
   the monitoring equipment (25) being programmed to generate a plurality of simple information of a mutually different typology, where:
   - each "typology of simple information" corresponds to a simple typology of operation
      performed by a predetermined typology of operating machine
   - each "simple information" corresponds to a single operation performed of said typology,
   - each simple information is recognized by the equipment based on all of the following parameters:
      - the typology of operating machine,
      - variations in the absorption spectrum with respect to a stand-by absorption of the operating machine,
      - based on the duration of the absorption variation,
- each simple information includes the time of execution of the operation;
- the monitoring equipment is programmed to generate a plurality of "complex information" of a mutually different typology, where each typology corresponds to a predetermined concatenation of simple information that identifies a typology of complex operation formed by a plurality of single predetermined operations performed in a predetermined time succession within a predetermined time period, and each complex information generated identifies a complex operation performed by the plurality of operating machines;
- the central processing and monitoring apparatus is suitable for displaying the number of complex operations performed and/or a datum dependent thereon.

Advantageously, the absorption variation time is comparable with a reference time that can be used as a threshold to establish whether the change is computable as a simple operation performed or not.

The typologies of simple predetermined operations recognized on the basis of the absorption comprise one or more of the following:

| | Simple operations |
|---|---|
| A | Lifting of a vehicle lifting machine (commonly called "bridge") |
| B | Lowering of a vehicle lifting machine |
| C | Rotation of the plate of a machine for disassembling tires from rims |
| D | Closing of the clamp of a balancing machine |
| E | Opening of the clamp of a balancing machine |
| F | Rotation of the tire on a balancing machine |
| G | Lifting of a machine for checking and/or adjusting the alignment |
| H | Lowering of a machine for checking and/or adjusting the alignment |
| J | Actuation of cameras of a machine for checking and/or adjusting the alignment |

The machines indicated are generally of the common typology, therefore their parts are not further described, being industry standards.

The complex operations that the equipment is programmed to recognize comprise one or more of the following concatenations:

| Complex operations | Execution order |
|---|---|
| Tire replacement | C + C |
| Tire balancing | D + F + E |
| Tire repair | A + C + C + B |
| Tire reversal | A + 4(D + F + E) + B |
| Single wheel replacement | A + 2C + D + F + E + B |
| Complete wheel replacement | A + 8C + 4 (D + F + E) + B |
| Alignment check | G + J + H |
| Alignment adjustment | G + J + G + J + H |

wherein

| | Simple operations |
|---|---|
| A | Lifting of a vehicle lifting machine (commonly called "bridge") |
| B | Lowering of a vehicle lifting machine |
| C | Rotation of the plate of a machine for disassembling tires from rims |
| D | Closing of the clamp of a balancing machine |
| E | Opening of the clamp of a balancing machine |
| F | Rotation of the tire on a balancing machine |
| G | Lifting of a machine for checking and/or adjusting the alignment |
| H | Lowering of a machine for checking and/or adjusting the alignment |
| J | Actuation of cameras of a machine for checking and/or adjusting the alignment |

According to a general preferred feature of the invention, each spectrum reading device is suitable for being interposed between an existing machine and an electric power supply network, in particular each device comprises:
- at least one electrical supply socket adapted to be connected to and disconnected from at least one electric machine to be monitored and to electrically power it,
- at least one connection of the device to an external power supply network to draw electricity,
- at least one sensor for measuring the electric current absorbed by the powered machine (and a possible absorption time detection device);
- data transmission means.

In this manner, it is advantageously not necessary to replace or adapt the machines present in the centers to be monitored. The equipment may for example be provided as kits where the detection devices each comprise at least a socket and a plug, so as to be interposed between the sockets of the electrical supply network and the supply plugs of the machines, the detection devices preferably form a switchboard.

According to some preferred embodiments, the system comprises:
- a plurality of service provision centers (5) remote from each other and from the central processing and monitoring apparatus (20), each center (5) comprising a plurality of operating machines (10) and a relative plurality of spectrum reading devices (15) placed online with the central processing and monitoring apparatus,
- the equipment being programmed to compute the complex operations of each center, associating the simple operations with each other only if they belong to the same center.

Said monitored system preferably comprises a plurality of service centers for vehicle tires, where each center comprises at least one of the following typologies of machines, more preferably all, connected to said monitoring equipment:
- tire disassembly machine;
- vehicle wheel alignment machine;
- vehicle lifting machine;
- machine for checking and/or adjusting the convergence of vehicle wheels.

According to claim 6, the invention comprises monitoring equipment of the typology indicated for the monitored system described above.

Preferably, said equipment is distinct from said operating machines and can be connected thereto by means of a method for engaging the reading devices between the power supply sockets of said machines and the electrical supply sockets of the electric network.

According clam 8, the invention relates to a method - calculating the number of individual random operations performed by each machine divided by typologies of operations that can be performed by said machine, where the recognition of each operation is made based on the variations of the electric absorption spectrum of said machine and their duration time;
- keeping track of the execution time of each simple operation;
- recognizing the execution of various typologies of complex operations composed of a plurality of simple operations by comparison with predetermined reference concatenations composed of simple operations carried out in temporal succession in a predetermined period;
- calculating the number of complex operations performed, whereby the simple operations and the complex operations are defined as in claim 1.

Advantageously, it is possible to compute the number of complex operations composed of simple operations performed by a plurality of mutually different machines.

Advantageously, it is also possible to centrally compute the number of complex operations performed in mutually remote service provision centers.

According to claim 8, it is provided to define parameters of simple reference operations to be compared with the parameters detected to count the simple operations performed, where said parameters include an absorption variation and a time defined as follows:
- performing a first predetermined number of individual operations by means of each machine,
- defining a reference absorption variation for each operation based on the absorptions detected during said first predetermined number of operations;
- setting a completion reference time for each typology of simple operation based on the times detected during said first predetermined number of operations.

Preferably, it is possible to define each reference concatenation as follows:
- performing at least one complex test operation isolated from other operations,
- storing the temporal succession in which its simple operations take place;
- setting a completion time for all its simple operations based on the time required to complete the complex test operation.

Advantageously with this method it is easy to calculate a monetary value by associating a predetermined monetary value with each complex computed operation.

According to the invention, the process comprises the step of providing one or more of assistance centers for vehicle tires, where the detected operations comprise one or more of the following:

| | Simple operations |
|---|---|
| A | Lifting of a vehicle lifting machine (commonly called "bridge") |
| B | Lowering of a vehicle lifting machine |
| C | Rotation of the plate of a machine for disassembling tires from rims |
| D | Closing of the clamp of a balancing machine |
| E | Opening of the clamp of a balancing machine |
| F | Rotation of the tire on a balancing machine |
| G | Lifting of a machine for checking and/or adjusting the alignment |
| H | Lowering of a machine for checking and/or adjusting the alignment |
| J | Actuation of cameras of a machine for checking and/or adjusting the alignment |

Further characteristics and advantages of the present invention will become clearer from the following detailed description of the preferred embodiments thereof, with reference to the appended drawings and provided by way of indicative and non-limiting example. In such drawings:
- figure 1 schematically shows a monitored system according to the present invention;
- figure 2 shows a monitored service provision center;
- figure 3 schematically shows a detection device of the system in figure 1;
- figure 4 shows the variation of the electric absorption spectrum of a car lifting machine during the performance of an operation.

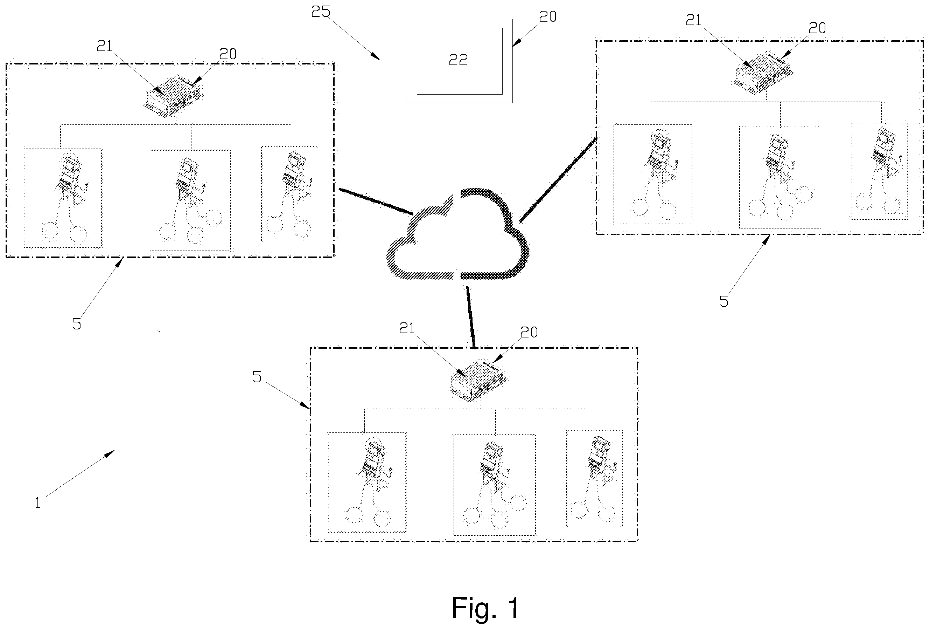

With reference to figure 1, a monitored system according to the invention is shown as a whole with reference numeral 1.

The system 1 comprises a plurality of centers for the provision of services to the public, preferably but not limited to vehicle tires, also called "branches" for simplicity, and indicated with reference numeral 5.

The centers 5 are in a mutually remote position, each being preferably contained in a relative building, so the order of magnitude of their distance is at least that between two buildings, more frequently at least that between two districts, even more frequently at least that between two inhabited centers.

Each center 5 comprises a plurality of electric absorption operating machines 10, that is, such as to use electric current during their operation. In the case of tires, each branch has at least the following machines 10, or a plurality of them:
- at least one machine for disassembling the tires from the rims, and preferably for the reassembly thereof;
- at least one vehicle wheel alignment machine;
- at least one vehicle lifting machine, generally called "bridge";
- at least one machine for checking and/or adjusting the convergence of vehicle wheels. In general, it comprises a dedicated bridge for lifting the vehicle and an equipment provided with cameras and mirrors for the wheel orientation analysis.

The monitored system 1 further comprises a monitoring equipment indicated as a whole with reference numeral 25, suitable for monitoring the number of operations performed by the machines 10.

The equipment 25 comprises at least one central processing and monitoring apparatus 20 and a plurality of devices for reading the electric absorption spectrum 15.

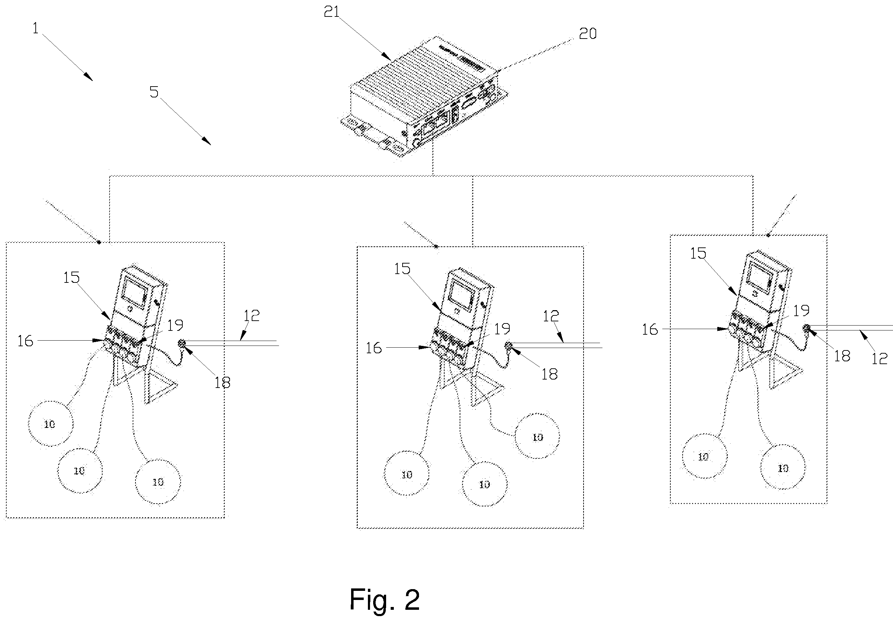

Each machine 10 is connected to an electrical supply network 12 by means of a device for reading the spectrum of its electric absorption 15. It is possible to provide one or more reading devices 15 for each center 5. The second case is shown in figure 2.

The central processing and monitoring apparatus 20 comprises at least one local data processing device 21, for example one for each center 5, placed in data communication with a plurality of reading devices 15 (the variant according to which there is one integrated in each of them is not excluded), and programmed or programmable for recognizing when a machine has performed an operation based on the variation of its electric absorption and to count the operations performed.

The local data processing devices 21 of all the centers are connected in a network with a remote data processing and/or display device 22 capable at least of displaying the processed data relating to all centers 5 in the network, being for example a PC. The network connection is a data exchange connection and takes place, for example, via the internet.

According to a possible alternative, there is a single data processing device 21 which processes the data of all the centers, and which receives the data from all the detection devices of all the centers. In this case, preferably the data processing device 21 coincides with the remote data processing and/or display device 22 and is networked with the detection devices 15.

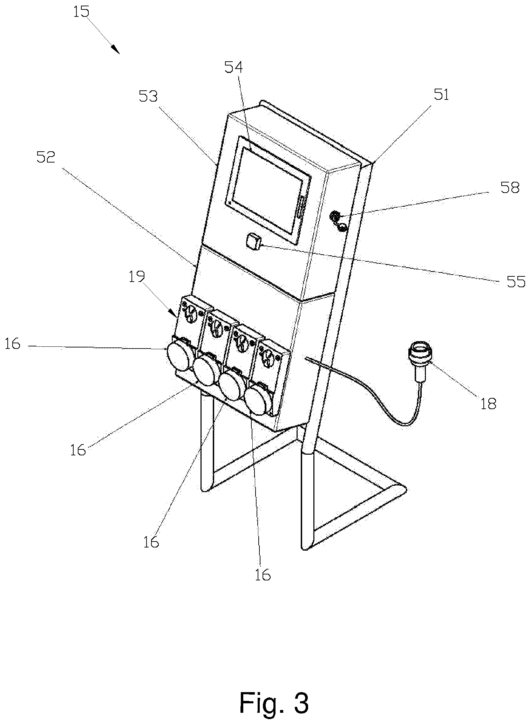

With reference to figure 3, a spectrum reading device 15 according to the invention is shown.

Each spectrum reading device 15 in particular comprises at least one current socket 16 to which a machine 10 can be connected to be powered, for example by means of an electric plug.

Preferably, the device 15 comprises a plurality of sockets 16, each dedicated to a respective machine 10.

It is not excluded that at least one spectrum reading device, preferably all, have a plurality of current sockets 16 of different typologies by amperage and voltage, preferably suitably protected by devices against overload.

The device comprises a second current connection plug 18 for connection to the electrical network 12.

The device 15 is suitable for detecting the electrical absorption of each machine connected thereto, for example by recording its absorption spectrum. To do this, the device 15 comprises at least one absorption sensor 19 for each socket 16.

According to the preferred embodiment shown in figure 3, the spectrum reading device 15 comprises a pedestal for the appropriate positioning 51 to which there are fixed a box-typology unit 52 for housing the electric sockets 16 and a box-typology unit 53 for housing a display and signaling device implemented by means of an LCD screen with touch-screen technology 54.

The spectrum reading device is also preferably provided with an RFID reader 55 for the identification of the operator by means of special encoded cards.

Each spectrum reading device 15 is preferably arranged with a variable amount of electrical sockets 16, different by amperage and voltage, at least one per typology, suitably protected by devices against overload to which a plurality of energy-powered operating machines are connected.

The system is powered through a power socket 18 to be connected to the electrical distribution system for easy integration with the pre-existing infrastructures.

The detected data are sent to the central processing and monitoring apparatus 20, in particular to the local processing device 21 or to the remote processing and/or display device 22, through a special wired output port 58 or wireless.

The central processing and/or display device 22 is placed for example in the central office of the company that manages all the branches.

In use, a programming step is performed which includes an initial setting step of the equipment 25. In the setting step, each machine 10 is connected to a relative spectrum reading device 15 and one or more operations are performed with them. During the operations, the spectrum of electric current absorbed at each operation is detected and is used to determine a reference spectrum corresponding to a simple operation to be counted as performed by the machine. Thereafter, during normal use of the set machine, the variation of its electric absorption is detected and the processing device 21 compares it with the reference absorption variation recorded in the setting. Based on the comparison, the processing device calculates the operations performed by the machine.

This process is repeated for each machine of the system 1, whereby the processing device 21 or 22 is able to have the information on the number of simple operations that can be considered performed by each of them.

Since some machines may be able to perform more than one typology of simple operation, it is possible to instruct the equipment 25 to recognize these typologies, and count them separately.

For example, the equipment 25 may be programmed or programmable to contain simple reference information, each comprising the association of a reference absorption variation and the relative reference absorption time set during the setting. The equipment is then programmed to generate simple information of the same typologies as the reference ones, deriving it from the data detected during ordinary use, and to compare it with the reference data to recognize the typology of simple operations performed and calculate the number thereof.

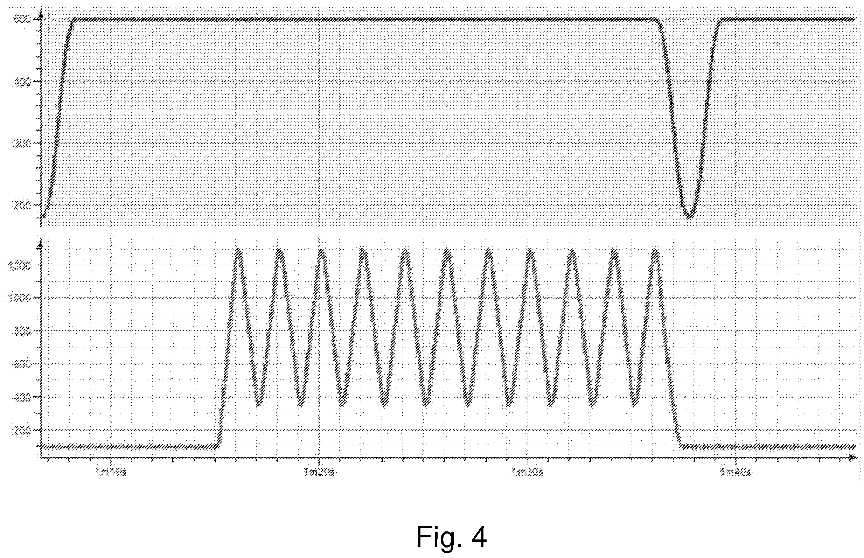

In figure 4 a typical absorption spectrum is visible, it shows a period of time in which the absorbed current is greater. The variation in absorption is therefore an increase in absorbed current. The absorbed current may fluctuate during an operation, so it is possible for example to consider its average value, or it is possible to consider a simple operation completed when the absorption returns to stand-by values for a period longer than a reference threshold. The absorption period and the average value of absorbed voltage may be considered as reference parameters corresponding to a simple operation. The spectrum shown corresponds to the lifting of a vehicle lifting machine.

The equipment 25 may be programmed or programmable to contain complex reference information, corresponding to associations of simple reference operations. Each complex reference information identifies an association of different simple operations performed by one or more machines of the same center. These associations of simple operations are called complex operations. The equipment 25 is then programmed to generate complex information of the same typologies as the reference ones, deriving it from the data detected during ordinary use, and to compare it with the reference data to recognize the complex operations performed and calculate the number thereof.

For example, in the case of tire service centers, the association of a simple operation of lifting a vehicle and a simple tire disassembly operation is computed as a complex tire replacement operation. The association of a simple lifting operation and four simple tire disassembly operations in sequence is counted as a complex operation to replace all the tires of the same car.

The system is preferably able to associate a cost to each operation in order to easily be able to issues invoices, or simply matching checks with what is invoiced by the branches.

### GENERAL INTERPRETATION OF TERMS

In understanding the object of the present invention, the term "comprising" and its derivatives, as used herein, are intended as open-ended terms that specify the presence of declared characteristics, elements, components, groups, integers and/or steps, but do not exclude the presence of other undeclared characteristics, elements, components, groups, integers and/or steps. The above also applies to words that have similar meanings such as the terms "comprised", "have" and their derivatives. Furthermore, the terms "part", "section", "portion", "member" or "element" when used in the singular can have the double meaning of a single part or a plurality of parts. As used herein to describe the above executive embodiment(s), the following directional terms "forward", "backward", "above", "under", "vertical", "horizontal", "below" and "transverse", as well as any other similar directional term, refers to the embodiment described in the operating position. Finally, terms of degree such as "mainly", "about" and "approximately" as used herein are intended as a reasonable amount of deviation of the modified term such that the final result is not significantly changed.

While only selected embodiments have been chosen to illustrate the present invention, it will be apparent from this description to those skilled in the art that various modifications and variations can be made without departing from the scope of the invention as defined in the appended claims. For example, the size, shape, position or orientation of the various components can be modified as needed and/or desired. The components shown which are directly connected or in contact with each other can have intermediate structures arranged between Therefore, the foregoing descriptions of the embodiments according to the present invention are provided for illustrative purposes only and not for the purpose of limiting the invention as defined by the appended claims

## Claims

1. Monitored system for the provision of services to the public, comprising:
- a plurality of electric absorption operating machines
comprising at least the following machines (10):
- at least one machine for disassembling the tires from the rims, and preferably for the reassembly thereof;
- at least one vehicle wheel alignment machine;
- at least one vehicle lifting machine, generally called "bridge";
- at least one machine for checking and/or adjusting the convergence of vehicle wheels.
- a monitoring equipment **characterised in that** the monitoring equipment comprises:
- at least one central processing and monitoring apparatus (20);
- at least a plurality of devices for reading the electric absorption spectrum (15), each associated with an operating machine (10), and being in data communication with the central processing and monitoring apparatus (20) or being part thereof;
- the monitoring equipment (25) being programmed to generate a plurality of simple information of a mutually different typology, where:
• each typology of simple information corresponds to a simple typology of operation
performed by a predetermined typology of operating machine
• each simple information corresponds to a single operation performed of said typology,
• each simple information is recognized by the monitoring equipment based on all the following parameters:
- the typology of operating machine,
- variations in the absorption spectrum with respect to a stand-by absorption of the operating machine,
- based on the duration of the absorption variation,
- each simple information includes the time of execution of the operation;
- the monitoring equipment is programmed to generate a plurality of complex information of a mutually different typology, where each typology corresponds to a predetermined concatenation of simple information that identifies a typology of complex operation formed by a plurality of single predetermined operations performed in a predetermined time succession within a predetermined time period, and each complex information generated identifies a complex operation performed by the plurality of operating machines;
- the central processing and monitoring apparatus is suitable for displaying the number of complex operations performed and/or a datum dependent thereon
the monitoring equipment is capable of computing the number of complex operations of various typologies composed of a plurality of simple operations performed by machines of various typologies by using the reading of the variations in the electrical absorption of the machines associated with the absorption time and the typology of machine, the monitoring equipment is capable to compare the absorption variation time with a reference time that is used as a threshold to establish whether the change is computable as a simple operation performed or not, in particular it is capable to consider a simple operation completed when the absorption returns to stand-by values for a period longer than a reference threshold, the typologies of simple predetermined operations recognized include one or more of the following:
| | Simple operations |
|---|---|
| A | Lifting of a vehicle lifting machine (commonly called "bridge") |
| B | Lowering of a vehicle lifting machine |
| C | Rotation of the plate of a machine for disassembling tires from rims |
| D | Closing of the clamp of a balancing machine |
| E | Opening of the clamp of a balancing machine |
| F | Rotation of the tire on a balancing machine |
| G | Lifting of an alignment machine |
| H | Lowering of an alignment machine |
| J | Actuation of cameras of an alignment machine |
and complex operations include one or more of the following concatenations:
| Complex operations | Execution order |
|---|---|
| Tire replacement | C + C |
| Tire balancing | D + F + E |
| Tire repair | A + C + C + B |
| Tire reversal | A + 4(D + F + E) + B |
| Single wheel replacement | A + 2C + D + F + E + B |
| Complete wheel replacement | A + 8C + 4(D + F + E) + B |
| Alignment check | G + J + H |
| Alignment adjustment | G + J + G + J + H |
wherein
| | Simple operations |
|---|---|
| A | Lifting of a vehicle lifting machine (commonly called "bridge") |
| B | Lowering of a vehicle lifting machine |
| C | Rotation of the plate of a machine for disassembling tires from rims |
| D | Closing of the clamp of a balancing machine |
| E | Opening of the clamp of a balancing machine |
| F | Rotation of the tire on a balancing machine |
| G | Lifting of an alignment machine |
| H | Lowering of an alignment machine |
| J | Actuation of cameras of an alignment machine |

2. System according to claim 1, **characterized in that** the absorbed current fluctuates during an operation, and its average value is considered as reference parameter corresponding to a simple operation.

3. System according to any one of the preceding claims, **characterized in that** each spectrum reading device (15) is suitable for being interposed between an existing machine (10) and an electric power supply network (12), in particular each device comprises:
- at least one electrical supply socket (16) adapted to be connected to and disconnected from at least one electric machine (10) to be monitored and to electrically power it,
- at least one connection (17) of the detection device (15) to an electrical supply network (12) for drawing electric current,
- at least one sensor (19) for measuring the electric current absorbed by the powered machine;
- data transmission means.

4. System according to claim 3, **characterized in that** the equipment is a kit (25) applicable to pre-existing machines (10) in centers for the provision of services to the public (5) to be monitored where the detection devices (15) each comprise at least a socket and a plug, so as to be interposed between the sockets of the electrical supply network (12) and the supply plugs of the machines (10), the detection devices (15) preferably form a switchboard (16).

5. System according to any one of the preceding claims, **characterized in that** it comprises:
- a plurality of centers for the provision of services to the public (5) remote from each other and from the central processing and monitoring apparatus (20), each center (5) comprising a plurality of operating machines (10) and a relative plurality of spectrum reading devices (15) placed online with the central processing and monitoring apparatus,
- the equipment being programmed to compute the complex operations of each center, associating the simple operations with each other only if they belong to the same center and each center comprises at least one of the machines (10) as defined in claim 1, more preferably all of said machines, connected to said monitoring equipment (25).

6. Monitoring equipment according to any one of the preceding claims.

7. Monitoring equipment according to claim 6, **characterized in that** it is distinct from said operating machines and can be connected thereto by means of a method for engaging the reading devices between the power supply sockets of said machines and the electrical supply sockets of the electric network.

8. Process for monitoring performed operations **characterized in that** it comprises the following steps:
- arranging a plurality of electric absorption operating machines (10) as defined in claim 1;
- performing a plurality of operations in a random manner by means of said plurality of machines;
- calculating the number of individual random operations performed by each machine divided by typologies of operations that can be performed by said machine, where the recognition of each operation is made based on the variations of the electric absorption spectrum of said machine and their duration time;
- keeping track of the execution time of each simple operation;
- recognizing the execution of various typologies of complex operations composed of a plurality of simple operations by comparison with predetermined reference concatenations composed of simple operations carried out in temporal succession in a predetermined period;
- calculating the number of complex operations performed, wherein the system compares the absorption variation time with a reference time that is used as a threshold to establish whether the change is computable as a simple operation performed or not, in particular it considers a simple operation completed when the absorption returns to stand-by values for a period longer than a reference threshold, the typologies of simple predetermined operations recognized include one or more of the following:
| | Simple operations |
|---|---|
| A | Lifting of a vehicle lifting machine (commonly called "bridge") |
| B | Lowering of a vehicle lifting machine |
| C | Rotation of the plate of a machine for disassembling tires from rims |
| D | Closing of the clamp of a balancing machine |
| E | Opening of the clamp of a balancing machine |
| F | Rotation of the tire on a balancing machine |
| G | Lifting of an alignment machine |
| H | Lowering of an alignment machine |
| J | Actuation of cameras of an alignment machine |
and complex operations include one or more of the following concatenations:
| Complex operations | Execution order |
|---|---|
| Tire replacement | C + C |
| Tire balancing | D + F + E |
| Tire repair | A + C + C + B |
| Tire reversal | A + 4(D + F + E) + B |
| Single wheel replacement | A + 2C + D + F + E + B |
| Complete wheel replacement | A + 8C + 4(D + F + E) + B |
| Alignment check | G + J + H |
| Alignment adjustment | G + J + G + J + H |
wherein
| | Simple operations |
|---|---|
| A | Lifting of a vehicle lifting machine (commonly called "bridge") |
| B | Lowering of a vehicle lifting machine |
| C | Rotation of the plate of a machine for disassembling tires from rims |
| D | Closing of the clamp of a balancing machine |
| E | Opening of the clamp of a balancing machine |
| F | Rotation of the tire on a balancing machine |
| G | Lifting of an alignment machine |
| H | Lowering of an alignment machine |
| J | Actuation of cameras of an alignment machine |
wherein the process defines parameters of simple reference operations to be compared with the parameters detected to count the simple operations performed, where said parameters include an absorption variation and a time defined as follows:
- performing a first predetermined number of individual operations by means of each machine,
- defining a reference absorption variation for each operation based on the absorptions detected during said first predetermined number of operations;
- setting a completion reference time for each typology of simple operation based on the times detected during said first predetermined number of operations.

9. Process according to claim 8, **characterized in that** it computes the number of complex operations composed of simple operations performed by a plurality of mutually different machines.

10. Process according to claim 8 or 9, **characterized by** centrally computing the number of complex operations performed in mutually remote centers for the provision of services to the public.

11. Process according to any one of claims 8 to 10, **characterized in that** each reference concatenation is defined as follows:
- performing at least one complex test operation isolated from other operations,
- storing the temporal succession in which its simple operations take place;
- setting a completion time for all its simple operations based on the time required to complete the complex test operation.

12. Process according to any one of claims 8 to 11, 1B, **characterized in that** it calculates a monetary value by associating a predetermined monetary value with each operation.

## Patentansprüche

1. Überwachtes System für die Erbringung von Dienstleistungen für die Öffentlichkeit, umfassend:
- eine Vielzahl von Strom absorbierenden Arbeitsmaschinen,
umfassend mindestens die folgenden Maschinen (10) :
- mindestens eine Maschine zur Demontage der Reifen von den Felgen und vorzugsweise zu deren Wiedermontage;
- mindestens eine Achsmessmaschine für Fahrzeuge;
- mindestens eine Fahrzeughebemaschine, im Allgemeinen "Hebebühne" genannt;
- mindestens eine Maschine zur Kontrolle und/oder Einstellung der Konvergenz der Fahrzeugräder.
- eine Überwachungsausrüstung, **gekennzeichnet durch**:
- mindestens eine zentrale Verarbeitungs- und Überwachungsvorrichtung (20);
- mindestens eine Vielzahl von Vorrichtungen zum Lesen des Stromabsorptionsspektrums (15), die jeweils einer Arbeitsmaschine (10) zugeordnet sind und in Datenkommunikation mit der zentralen Verarbeitungs- und Überwachungsvorrichtung (20) stehen oder Teil davon sind;
- wobei die Überwachungsausrüstung (25) so programmiert ist, dass sie eine Vielzahl von einfachen Informationen einer voneinander verschiedenen Typologie erzeugt, wobei:
• jede Typologie der einfachen Information einer einfachen Typologie der Operation entspricht,
die von einer vorgegebenen Typologie von Arbeitsmaschine ausgeführt wird
• jede einfache Information einer einzigen ausgeführten Operation der genannten Typologie entspricht,
• jede einfache Information von der Überwachungsausrüstung auf der Grundlage aller der folgenden Parameter erkannt wird:
- die Typologie der Arbeitsmaschine,
- Schwankungen des Absorptionsspektrums in Bezug auf eine Stand-by-Absorption der Arbeitsmaschine,
- basierend auf der Dauer der Absorptionsänderung,
- jede einfache Information enthält den Zeitpunkt der Ausführung der Operation;
- die Überwachungseinrichtung ist so programmiert, dass sie eine Vielzahl komplexer Informationen einer voneinander verschiedenen Typologie erzeugt, wobei jede Typologie einer vorgegebenen Verkettung einfacher Informationen entspricht, die eine Typologie einer komplexen Operation identifiziert, die durch eine Vielzahl einzelner vorgegebener Operationen gebildet wird, die in einer vorgegebenen zeitlichen Abfolge innerhalb einer vorgegebenen Zeitspanne ausgeführt werden, und jede erzeugte komplexe Information eine komplexe Operation identifiziert, die von der Vielzahl von Arbeitsmaschinen ausgeführt wird;
- die zentrale Verarbeitungs- und Überwachungsvorrichtung ist geeignet, die Anzahl der ausgeführten komplexen Operationen und/oder eine davon abhängige Größe anzuzeigen
die Überwachungsausrüstung ist in der Lage, die Anzahl der komplexen Operationen verschiedener Typologien zu berechnen, die sich aus einer Vielzahl von einfachen Operationen zusammensetzen, die von Maschinen verschiedener Typologien ausgeführt werden, indem sie das Ablesen der Veränderungen der elektrischen Absorption der Maschinen in Verbindung mit der Absorptionszeit und der Maschinentypologie verwendet, die Überwachungsausrüstung ist in der Lage, die Änderungszeit der Absorption mit einer Referenzzeit zu vergleichen, die als Schwellenwert verwendet wird, um festzustellen, ob die Änderung als eine ausgeführte einfache Operation berechnet werden kann oder nicht, insbesondere ist sie in der Lage, eine einfache Operation als abgeschlossen zu betrachten, wenn die Absorption für einen Zeitraum, der länger als ein Referenzschwellenwert ist, zu den Stand-by-Werten zurückkehrt, wobei die erkannten Typologien einfacher vorgegebener Operationen eine oder mehrere der folgenden umfassen:
| | Einfache Operationen |
|---|---|
| A | Anheben einer Fahrzeughebemaschine (gemeinhin "Hebebühne" genannt) |
| B | Absenken einer Fahrzeughebemaschine |
| C | Drehen der Platte einer Maschine zur Demontage von Reifen von Felgen |
| D | Schließen der Klemme einer Auswuchtmaschine |
| E | Öffnen der Klemme einer Auswuchtmaschine |
| F | Drehen des Reifens auf einer Auswuchtmaschine |
| G | Anheben einer Achsmessmaschine |
| H | Absenken einer Achsmessmaschine |
| J | Ansteuern von Kameras einer Achsmessmaschine |
und komplexe Operationen eine oder mehrere der folgenden Verkettungen umfassen:
| Komplexe Operationen | Ausführungsreihenfolge |
|---|---|
| Reifenwechsel | C + C |
| Reifenwuchten | D + F + E |
| Reifenreparatur | A + C + C + B |
| Reifentausch | A + 4(D + F + E) + B |
| Einzelradwechsel | A + 2C + D + F + E + B |
| Komplettradwechsel | A + 8C + 4(D + F + E) + B |
| Achsmessprüfung | G + J + H |
| Achsmesseinstellung | G + J + G + J + H |
wobei
| | Einfache Operationen |
|---|---|
| A | Anheben einer Fahrzeughebemaschine (gemeinhin "Hebebühne" genannt) |
| B | Absenken einer Fahrzeughebemaschine |
| C | Drehen der Platte einer Maschine zur Demontage von Reifen von Felgen |
| D | Schließen der Klemme einer Auswuchtmaschine |
| E | Öffnen der Klemme einer Auswuchtmaschine |
| F | Drehen des Reifens auf einer Auswuchtmaschine |
| G | Anheben einer Achsmessmaschine |
| H | Absenken einer Achsmessmaschine |
| J | Ansteuern von Kameras einer Achsmessmaschine |

2. System nach Anspruch 1, **dadurch gekennzeichnet, dass** der absorbierte Strom während einer Operation schwankt und sein Durchschnittswert als Referenzparameter betrachtet wird, der einer einfachen Operation entspricht.

3. System nach einem der vorstehenden Ansprüche, **dadurch gekennzeichnet, dass** jede Spektrumlesevorrichtung (15) geeignet ist, zwischen einer vorhandenen Maschine (10) und einem elektrischen Versorgungsnetz (12) angeordnet zu werden, insbesondere umfasst jede Vorrichtung:
- mindestens eine Steckdose (16), die eingerichtet ist, um mit mindestens einer elektrischen Maschine (10) verbunden und von ihr getrennt zu werden, die zu überwachen und mit Strom zu versorgen ist,
- mindestens einen Anschluss (17) der Detektionsvorrichtung (15) an ein elektrisches Versorgungsnetz (12) zur Entnahme von elektrischem Strom,
- mindestens einen Sensor (19) zur Messung des von der angetriebenen Maschine absorbierten elektrischen Stroms;
- Datenübertragungsmittel.

4. System nach Anspruch 3, **dadurch gekennzeichnet, dass** die Ausrüstung ein Bausatz (25) ist, der für bereits vorhandene Maschinen (10) in Zentren für die Erbringung von zu überwachenden Dienstleistungen für die Öffentlichkeit (5) anwendbar ist, wobei die Detektionsvorrichtungen (15) jeweils mindestens eine Steckdose und einen Stecker umfassen, um zwischen den Steckdosen des elektrischen Versorgungsnetzes (12) und den Versorgungssteckern der Maschinen (10) angeordnet zu werden, wobei die Detektionsvorrichtungen (15) vorzugsweise einen Schaltschrank (16) bilden.

5. System nach einem der vorstehenden Ansprüche, **dadurch gekennzeichnet, dass** es umfasst:
- eine Vielzahl von Zentren für die Erbringung von Dienstleistungen für die Öffentlichkeit (5), die voneinander und von der zentralen Verarbeitungs- und Überwachungsvorrichtung (20) entfernt sind, wobei jedes Zentrum (5) eine Vielzahl von Arbeitsmaschinen (10) und eine relative Vielzahl von Spektrumlesevorrichtungen (15) umfasst, die mit der zentralen Verarbeitungs- und Überwachungsvorrichtung online geschaltet sind,
- wobei die Ausrüstung so programmiert ist, dass sie die komplexen Operationen jedes Zentrums berechnet und die einfachen Operationen nur dann einander zuordnet, wenn sie zu demselben Zentrum gehören und jedes Zentrum mindestens eine, vorzugsweise alle, der in Anspruch 1 definierten Maschinen (10) umfasst, die mit der Überwachungsausrüstung (25) verbunden sind:

6. Überwachungsausrüstung nach einem der vorstehenden Ansprüche.

7. Überwachungsausrüstung nach Anspruch 6, **dadurch gekennzeichnet, dass** sie sich von den Arbeitsmaschinen unterscheidet und mit diesen mittels eines Verfahrens zum Einschalten der Lesevorrichtungen zwischen den Stromsteckdosen der Maschinen und den Steckdosen des elektrischen Netzwerks verbunden werden kann.

8. Verfahren zur Überwachung von ausgeführten Operationen, **dadurch gekennzeichnet, dass** es die folgenden Schritte umfasst:
- Anordnen einer Vielzahl von elektrischen Absorptionsmaschinen (10), wie in Anspruch 1 definiert;
- Ausführen einer Vielzahl von Operationen in einer zufälligen Weise mittels der Vielzahl von Maschinen;
- Berechnen der Anzahl von einzelnen zufälligen Operationen, die von jeder Maschine ausgeführt werden, geteilt durch die Typologien von Operationen, die von der Maschine ausgeführt werden können, wobei das Erkennen jeder Operation auf der Grundlage der Veränderungen des elektrischen Absorptionsspektrums der Maschine und ihrer Zeitdauer erfolgt;
- Verfolgen der Ausführungszeit jeder einfachen Operation;
- Erkennen der Ausführung verschiedener Typologien komplexer Operationen, die sich aus einer Vielzahl einfacher Operationen zusammensetzen, durch Vergleich mit vorgegebenen Referenzverkettungen, die sich aus einfachen Operationen zusammensetzen, die in zeitlicher Abfolge in einem vorgegebenen Zeitraum ausgeführt werden;
- Berechnen der Anzahl ausgeführter komplexer Operationen, wobei das System die Absorptionsänderungszeit mit einer Referenzzeit vergleicht, die als Schwellenwert verwendet wird, um festzustellen, ob die Änderung als eine ausgeführte einfache Operation berechnet werden kann oder nicht, insbesondere betrachtet es eine einfache Operation als abgeschlossen, wenn die Absorption für einen Zeitraum, der länger als ein Referenzschwellenwert ist, zu den Stand-by-Werten zurückkehrt, wobei die erkannten Typologien einfacher vorgegebener Operationen eine oder mehrere der folgenden umfassen:
| | Einfache Operationen |
|---|---|
| A | Anheben einer Fahrzeughebemaschine (gemeinhin "Hebebühne" genannt) |
| B | Absenken einer Fahrzeughebemaschine |
| C | Drehen der Platte einer Maschine zur Demontage von Reifen von Felgen |
| D | Schließen der Klemme einer Auswuchtmaschine |
| E | Öffnen der Klemme einer Auswuchtmaschine |
| F | Drehen des Reifens auf einer Auswuchtmaschine |
| G | Anheben einer Achsmessmaschine |
| H | Absenken einer Achsmessmaschine |
| J | Ansteuern von Kameras einer Achsmessmaschine |
und komplexe Operationen eine oder mehrere der folgenden Verkettungen umfassen:
| Komplexe Operationen | Ausführungsreihenfolge |
|---|---|
| Reifenwechsel | C + C |
| Reifenwuchten | D + F + E |
| Reifenreparatur | A + C + C + B |
| Reifentausch | A + 4(D + F + E) + B |
| Einzelradwechsel | A + 2C + D + F + E + B |
| Komplettradwechsel | A + 8C + 4(D + F + E) + B |
| Achsmessprüfung | G + J + H |
| Achsmesseinstellung | G + J + G + J + H |
wobei
| | Einfache Operationen |
|---|---|
| A | Anheben einer Fahrzeughebemaschine (gemeinhin "Hebebühne" genannt) |
| B | Absenken einer Fahrzeughebemaschine |
| C | Drehen der Platte einer Maschine zur Demontage von Reifen von Felgen |
| D | Schließen der Klemme einer Auswuchtmaschine |
| E | Öffnen der Klemme einer Auswuchtmaschine |
| F | Drehen des Reifens auf einer Auswuchtmaschine |
| G | Anheben einer Achsmessmaschine |
| H | Absenken einer Achsmessmaschine |
| J | Ansteuern von Kameras einer Achsmessmaschine |
wobei das Verfahren Parameter von einfachen Referenzoperationen definiert, die mit den Parametern verglichen werden, die zur Zählung der ausgeführten einfachen Operationen erfasst werden, wobei die Parameter eine Absorptionsänderung und eine Zeit umfassen, die wie folgt definiert sind:
- Ausführen einer ersten vorgegebenen Anzahl von Einzeloperationen mittels jeder Maschine,
- Definieren einer Referenzabsorptionsänderung für jede Operation auf der Grundlage der während der ersten vorgegebenen Anzahl von Operationen detektierten Absorptionen;
- Festlegen einer Referenzzeit für die Beendigung jeder Typologie von einfachen Operationen auf der Grundlage der während der ersten vorgegebenen Anzahl von Operationen detektierten Zeiten.

9. Verfahren nach Anspruch 8, **dadurch gekennzeichnet, dass** es die Anzahl komplexer Operationen berechnet, die sich aus einfachen Operationen zusammensetzen, die von einer Vielzahl von voneinander verschiedenen Maschinen ausgeführt werden.

10. Verfahren nach Anspruch 8 oder 9, **dadurch gekennzeichnet, dass** die Anzahl komplexer Operationen, die in voneinander entfernten Zentren zur Erbringung von Dienstleistungen für die Öffentlichkeit ausgeführt werden, zentral berechnet wird.

11. Verfahren nach einem der Ansprüche 8 bis 10, **dadurch gekennzeichnet, dass** jede Referenzverkettung wie folgt definiert ist:
- Durchführen mindestens einer komplexen Testoperation getrennt von anderen Operationen,
- Speichern der zeitlichen Abfolge, in der die einfachen Operationen ablaufen;
- Festlegen einer Fertigstellungszeit für alle einfachen Operationen auf der Grundlage der für den Abschluss der komplexen Testoperation erforderlichen Zeit.

12. Verfahren nach einem der Ansprüche 8 bis 11, **dadurch gekennzeichnet, dass** es einen Geldwert berechnet, indem es jeder Operation einen vorgegebenen Geldwert zuordnet.

## Revendications

1. Système surveillé pour la fourniture de services au public, comprenant :
- une pluralité de machines d'exploitation à absorption électrique
comprenant au moins les machines suivantes (10) :
- au moins une machine pour le démontage des pneus des jantes et, de préférence, pour leur remontage ;
- au moins une machine d'alignement des roues de véhicules ;
- au moins une machine de levage de véhicules, généralement appelé « pont » ;
- au moins une machine pour le contrôle et/ou le réglage de la convergence de roues de véhicule,
- un équipement de surveillance **caractérisé en ce que** :
- au moins un appareil central de traitement et de surveillance (20) ;
- au moins une pluralité de dispositifs de lecture du spectre d'absorption électrique (15), chacun étant associé à une machine d'exploitation (10) et étant en communication de données avec l'appareil central de traitement et de surveillance (20) ou faisant partie de celui-ci ;
- l'équipement de surveillance (25) est programmé pour générer une pluralité d'informations simples d'une typologie mutuellement différente, dans lequel :
• chaque typologie d'information simple correspond à une typologie d'opération simple
réalisée par une typologie prédéterminée de machine d'exploitation
• chaque information simple correspond à une seule opération réalisée de ladite typologie,
• chaque information simple est reconnue par l'équipement de surveillance sur la base de tous les paramètres suivants :
- la typologie d'une machine d'exploitation,
- des variations du spectre d'absorption par rapport à une absorption de veille de la machine d'exploitation,
- sur la base de la durée de la variation d'absorption,
- chaque information simple comprend l'heure d'exécution de l'opération ;
- l'équipement de surveillance est programmé pour générer une pluralité d'informations complexes d'une typologie mutuellement différente, dans lequel chaque typologie correspond à une concaténation prédéterminée d'informations simples qui identifient une typologie d'opération complexe formée par une pluralité d'opérations prédéterminées individuelles réalisées dans une succession temporelle prédéterminée au cours d'une période de temps prédéterminée, et chaque information complexe générée identifie une opération complexe réalisée par la pluralité de machines d'exploitation ;
- l'appareil central de traitement et de surveillance est adapté pour afficher le nombre d'opérations complexes réalisées et/ou une donnée qui en dépend
l'équipement de contrôle est apte à calculer le nombre d'opérations complexes de différentes typologies composées d'une pluralité d'opérations simples réalisées par des machines de différentes typologies en utilisant la lecture des variations de l'absorption électrique des machines associées au temps d'absorption et à la typologie de la machine, l'équipement de surveillance est apte à comparer le temps de variation d'absorption avec un temps de référence qui est utilisé comme un seuil pour établir si le changement est ou non calculable comme une opération simple réalisée, en particulier il est apte à considérer une opération simple terminée lorsque l'absorption revient à des valeurs de veille pendant une période plus longue qu'un seuil de référence, les typologies d'opérations simples prédéterminées reconnues comprennent une ou plusieurs des suivantes :
| | Opérations simples |
|---|---|
| A | Levage d'une machine de levage de véhicule (communément appelé « pont ») |
| B | Abaissement d'une machine de levage de véhicule |
| C | Rotation du plateau d'une machine de démontage de pneus des jantes |
| D | Fermeture de la pince d'une machine d'équilibrage |
| E | Ouverture de la pince d'une machine d'équilibrage |
| F | Rotation du pneu sur une machine d'équilibrage |
| G | Levage d'une machine d'alignement |
| H | Abaissement d'une machine d'alignement |
| J | Actionnement de caméras d'une machine d'alignement |
et des opérations complexes comprennent une ou plusieurs des concaténations suivantes :
| Opérations complexes | Ordre d'exécution |
|---|---|
| Remplacement des pneus | C + C |
| Equilibrage des pneus | D + F + E |
| Réparation des pneus | A + C + C + B |
| Inversion des pneus | A + 4(D + F + E) + B |
| Remplacement d'une seule roue | A + 2C + D + F + E + B |
| Remplacement complet des roues | A + 8C + 4(D + F + E) + B |
| Contrôle d'alignement | G + J + H |
| Réglage d'alignement | G + J + G + J + H |
dans lequel
| | Opérations simples |
|---|---|
| A | Levage d'une machine de levage de véhicule (communément appelé « pont ») |
| B | Abaissement d'une machine de levage de véhicule |
| C | Rotation du plateau d'une machine de démontage de pneus des jantes |
| D | Fermeture de la pince d'une machine d'équilibrage |
| E | Ouverture de la pince d'une machine d'équilibrage |
| F | Rotation du pneu sur une machine d'équilibrage |
| G | Levage d'une machine d'alignement |
| H | Abaissement d'une machine d'alignement |
| J | Actionnement de caméras d'une machine d'alignement |

2. Système selon la revendication 1, **caractérisé en ce que** le courant absorbé fluctue au cours d'une opération, et que sa valeur moyenne est considérée comme un paramètre de référence correspondant à une opération simple.

3. Système selon l'une quelconque des revendications précédentes, **caractérisé en ce que** chaque dispositif de lecture de spectre (15) est adapté pour être interposé entre une machine existante (10) et un réseau d'alimentation électrique (12), en particulier chaque dispositif comprend :
- au moins une prise d'alimentation électrique (16) adaptée pour être connectée et déconnectée par rapport à au moins une machine électrique (10) à surveiller et pour l'alimenter électriquement,
- au moins une connexion (17) du dispositif de détection (15) à un réseau d'alimentation électrique (12) pour tirer du courant électrique,
- au moins un capteur (19) pour mesurer le courant électrique absorbé par la machine alimentée ;
- des moyens de transmission des données.

4. Système selon la revendication 3, **caractérisé en ce que** l'équipement est un kit (25) applicable à des machines préexistantes (10) dans des centres de fourniture de services au public (5) à surveiller, dans lequel les dispositifs de détection (15) comprennent chacun au moins une prise et une fiche, de manière à être interposés entre les prises du réseau d'alimentation électrique (12) et les fiches d'alimentation des machines (10), les dispositifs de détection (15) forme de préférence un tableau de distribution (16).

5. Système selon l'une quelconque des revendications précédentes, **caractérisé en ce qu'**il comprend :
- une pluralité de centres de fourniture de services au public (5) éloignés les uns des autres et de l'appareil central de traitement et de surveillance (20), chaque centre (5) comprenant une pluralité de machines d'exploitation (10) et une pluralité correspondante de dispositifs de lecture du spectre (15) mis en ligne avec l'appareil central de traitement et de surveillance,
- l'équipement étant programmé pour calculer les opérations complexes de chaque centre, en associant les opérations simples entre elles uniquement si elles appartiennent au même centre et chaque centre comprend au moins une des machines (10) telles que définies dans la revendication 1, plus préférablement la totalité, connectée audit équipement de surveillance (25).

6. Équipement de surveillance selon l'une des revendications précédentes.

7. Équipement de surveillance selon la revendication 6, **caractérisé en ce qu'**il est distinct desdites machines d'exploitation et peut y être connecté au moyen d'un procédé d'engagement des dispositifs de lecture entre les prises d'alimentation électrique desdites machines et les prises d'alimentation électrique du réseau électrique.

8. Procédé de surveillance d'opérations réalisées, **caractérisé en ce qu'**il comprend les étapes suivantes :
- l'agencement d'une pluralité de machines d'exploitation à absorption électrique (10) telles que définies dans la revendication 1 ;
- la réalisation d'une pluralité d'opérations de manière aléatoire au moyen de ladite pluralité de machines ;
- le calcul du nombre d'opérations aléatoires individuelles réalisées par chaque machine, divisé par typologies d'opérations pouvant être réalisées par ladite machine, dans lequel la reconnaissance de chaque opération est réalisée sur la base des variations du spectre d'absorption électrique de ladite machine et de leur durée ;
- le suivi du temps d'exécution de chaque opération simple ;
- la reconnaissance de l'exécution de différentes typologies d'opérations complexes composées d'une pluralité d'opérations simples par comparaison avec des concaténations de référence prédéterminées composées d'opérations simples réalisées en succession temporelle dans une période prédéterminée ;
- le calcul du nombre d'opérations complexes réalisées, dans lequel le système compare le temps de variation d'absorption à un temps de référence qui est utilisé comme un seuil pour établir si le changement est ou non calculable comme une opération simple réalisée, en particulier il considère une opération simple terminée lorsque l'absorption revient à des valeurs de veille pendant une période plus longue qu'un seuil de référence, les typologies d'opérations simples prédéterminées reconnues comprennent une ou plusieurs des suivantes :
| | Opérations simples |
|---|---|
| A | Levage d'une machine de levage de véhicule (communément appelé « pont ») |
| B | Abaissement d'une machine de levage de véhicule |
| C | Rotation du plateau d'une machine de démontage de pneus des jantes |
| D | Fermeture de la pince d'une machine d'équilibrage |
| E | Ouverture de la pince d'une machine d'équilibrage |
| F | Rotation du pneu sur une machine d'équilibrage |
| G | Levage d'une machine d'alignement |
| H | Abaissement d'une machine d'alignement |
| J | Actionnement de caméras d'une machine d'alignement |
et des opérations complexes comprennent une ou plusieurs des concaténations suivantes :
| Opérations complexes | Ordre d'exécution |
|---|---|
| Remplacement des pneus | C + C |
| Equilibrage des pneus | D + F + E |
| Réparation des pneus | A + C + C + B |
| Inversion des pneus | A + 4(D + F + E) + B |
| Remplacement d'une seule roue | A + 2C + D + F + E + B |
| Remplacement complet des roues | A + 8C + 4(D + F + E) + B |
| Contrôle d'alignement | G + J + H |
| Réglage d'alignement | G + J + G + J + H |
dans lequel
| | Opérations simples |
|---|---|
| A | Levage d'une machine de levage de véhicule (communément appelé « pont ») |
| B | Abaissement d'une machine de levage de véhicule |
| C | Rotation du plateau d'une machine de démontage de pneus des jantes |
| D | Fermeture de la pince d'une machine d'équilibrage |
| E | Ouverture de la pince d'une machine d'équilibrage |
| F | Rotation du pneu sur une machine d'équilibrage |
| G | Levage d'une machine d'alignement |
| H | Abaissement d'une machine d'alignement |
| J | Actionnement de caméras d'une machine d'alignement |
dans lequel le processus définit des paramètres d'opérations de référence simples à comparer aux paramètres détectés pour compter les opérations simples réalisées, dans lequel lesdits paramètres comprennent une variation d'absorption et un temps définis comme suit :
- la réalisation d'un premier nombre prédéterminé d'opérations individuelles au moyen de chaque machine,
- la définition d'une variation d'absorption de référence pour chaque opération sur la base des absorptions détectées au cours dudit premier nombre prédéterminé d'opérations ;
- la définition d'un temps de référence de terminaison pour chaque typologie d'opération simple sur la base des temps détectés au cours dudit premier nombre prédéterminé d'opérations.

9. Procédé selon la revendication 8, **caractérisé en ce qu'**il calcule le nombre d'opérations complexes composées d'opérations simples réalisées par une pluralité de machines mutuellement différentes.

10. Procédé selon la revendication 8 ou 9, **caractérisé par** le calcul centralisé du nombre d'opérations complexes réalisées dans des centres mutuellement distants pour la fourniture de services au public.

11. Procédé selon l'une quelconque des revendications 8 à 10, **caractérisé en ce que** chaque concaténation de référence est définie comme suit :
- la réalisation d'au moins une opération de test complexe isolée d'autres opérations,
- le stockage de la succession temporelle dans laquelle se déroulent ses opérations simples ;
- l'établissement d'un temps de terminaison pour toutes ses opérations simples sur la base du temps nécessaire pour terminer l'opération de test complexe.

12. Procédé selon l'une quelconque des revendications 8 à 11, **caractérisé en ce qu'**il calcule une valeur monétaire en associant à chaque opération une valeur monétaire prédéterminée.
